# EUROPÄISCHE PATENTANMELDUNG

(11) **EP 1 916 766 A2**
(43) Veröffentlichungstag der Anmeldung: **30.04.2008**
(21) Anmeldenummer: 07019679.5
(22) Anmeldetag: 09.10.2007
(51) Int. Cl.: H03G 3/30

(54) **Regelschaltung**

(30) Priorität: 25.10.2006 DE 102006050124
(71) Anmelder: EADS Deutschland GmbH, 85521 Ottobrunn (DE)
(72) Erfinder: Prediger, Nikolaus, 89079 Ulm (DE); Heller, Helmut, 89134 Blaustein (DE)
(74) Vertreter: Riegel, Werner

(57) **Zusammenfassung**

Die Erfindung betrifft eine Schaltung zur Amplitudenregelung von HF-Pulssignalen umfassend ein digital einstellbares Dämpfungsglied (1) mit einem vorgebbaren Stellwertbereich zur Dämpfung eines am Eingang (1a) des Dämpfungsgliedes (1) zugeführten HF-Pulssignals (9), einen A/D-Wandler (4) zur Umsetzung der Abweichung des Istpegels des am Ausgang (1 b) des Dämpfungsgliedes (1) erzeugten Istsignals vom Sollpegel in ein digitales Datenwort, ein digitales Rechenwerk (3) zur Ermittlung eines durch den Regeltaktgeber (12) taktsynchronen Stellwertes für das Dämpfungsglied (1) aus dem digitalen Datenwort, wobei ein Regeltaktgeber (12) vorhanden ist zur zeitrichtigen Weitergabe des ermittelten Stellwertes auf das Pulsdach desjenigen Pulses für welchen die Regelabweichung ermittelt wurde.

## Beschreibung

Die Erfindung betrifft eine Schaltung zur Regelung eines HF-Pulssignals gemäß dem Oberbegriff des Patentanspruchs 1.

Bekannte analoge Regelschaltungen arbeiten nach dem Prinzip der Iteration, wobei der Istwert in einer Vielzahl von lterationsschritten an den Sollwert angenähert wird.

Die Regelgeschwindigkeit stellt dabei immer einen Kompromiss zwischen Bandbreite, Stabilität und Einschwingverhalten dar uns ist abhängig vom Betrag der Regelabweichung.

Analoge Regelschaltungen arbeiten zeitkontinuierlich, d.h. es findet ein ständiger Vergleich zwischen Soll- und Istwert statt. Bei Pulssignalen muss daher der Ist-Wert zwischen Pulsdächern aufeinander folgender Pulse gehalten werden, damit der Regelvorgang beim nächsten Pulssignal fortgesetzt werden kann. Die Ausregelung der Regelabweichung erstreckt sich so über mehrere Pulse.

Eine solche Schaltung umfassend ein digital einstellbares Dämpfungsglied mit einem vorgebbaren Stellwertbereich zur Dämpfung eines HF-Pulssignals, einen A/D-Wandler zur Umsetzung der Abweichung des Istpegels vom Sollpegel in ein digitales Datenwort und ein digitales taktsynchrones Rechenwerk zur Ermittlung eines Stellwertes für das Dämpfungsglied aus dem digitalen Datenwort ist aus DE 44 97 317 T1 bekannt.

Ein Puls ist durch seine sprunghafte Änderung in seinem Spannungs- oder Strompegel charakterisiert. Er zeichnet sich durch einen steilen Übergang zwischen zwei Pegeln aus: der eine Pegel bildet den Pulsboden, der zweite Pegel, der nach dem Pegelsprung für die Pulsdauer ein konstanter Pegelwert hat, bildet das Pulsdach.

Es ist Aufgabe der Erfindung eine Regelschaltung anzugeben, mit welcher ein Istwert noch innerhalb eines Einzelpulses zuverlässig auf den Sollwert geregelt werden kann.

Diese Aufgabe wird mit der Schaltung gemäß den Merkmalen des Anspruchs 1 gelöst. Vorteilhafte Ausführungen der Schaltung sind Gegenstand von Unteransprüchen.

Bei der erfindungsgemäßen Schaltung ist die Regelzeit, d.h. die Zeit die benötigt wird um den Sollwert zu erreichen, unabhängig von der Regelabweichung. Der Sollwert der Regelgröße wird mit der erfindungsgemäßen Schaltung somit unabhängig vom Betrag der Regelabweichung immer nach einem einzigen Regelvorgang erreicht, wobei dieser Regelvorgang innerhalb eines einzelnen Pulses abgeschlossen ist. Ein Regeltaktgeber sorgt dafür, daß der ermittelte Stellwert zeitrichtig auf das Pulsdach desjenigen Pulses für welchen die Regelabweichung ermittelt wurde gegeben wird.

Mit der erfindungsgemäßen Schaltung können somit Amplituden von beliebigen Pulssignalen geregelt werden wenn die Regelschaltung zeitrichtig angepasst wird.

Mit der erfindungsgemäßen Schaltung ist es einerseits möglich, dass der Regelvorgang nur während HF-Pulssignalen durchgeführt wird und die Zeit zwischen den HF-Pulsen dabei ausgeblendet wird. Unabhängig vom Betrag der Regelabweichung ist immer nach einem einzigen Regelvorgang der Sollwert erreicht, wobei dieser Regelvorgang innerhalb eines einzelnen Pulses abgeschlossen ist.
Alternativ kann der Regelvorgang nur an einem HF-Pulssignal durchgeführt werden und für eine folgende Pulssequenz der Regelvorgang eingefroren bleiben.

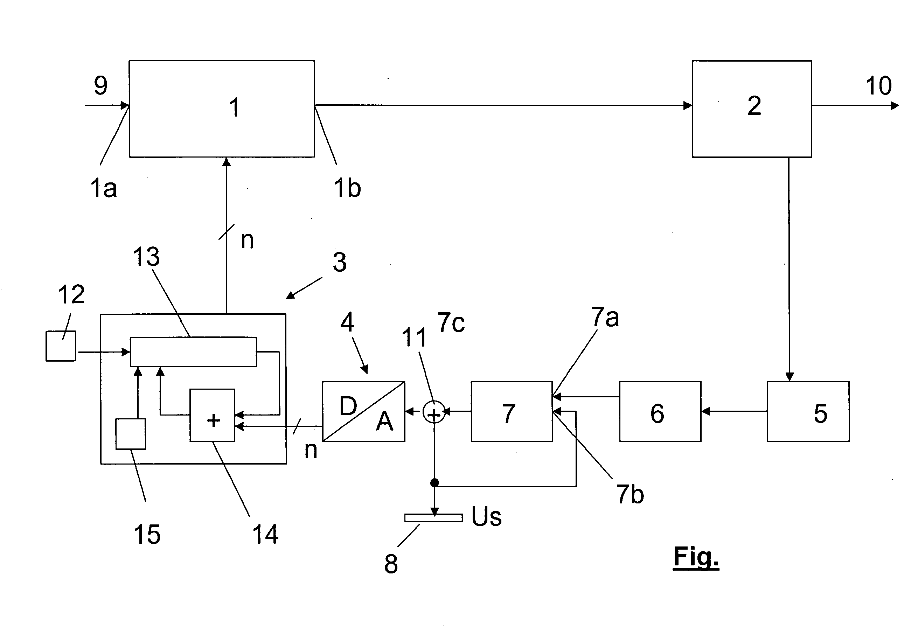

Die erfindungsgemäße Schaltung sowie vorteilhafte Ausführungen der Schaltung werden anhand der einzigen Fig. näher erläutert.

Die Fig. zeigt eine erfindungsgemäße Schaltung zur Amplitudenregelung von HF-Pulssignalen 9 umfassend ein digital einstellbares Dämpfungsglied 1 mit einem vorgebbaren Stellwertbereich zur Dämpfung eines am Eingang 1a des Dämpfungsgliedes 1 zugeführten HF-Pulssignals 9, einen Analog/Digital-Wandler 4 zur Umsetzung der Abweichung des Istpegels in ein digitales Datenwort sowie ein digitales Rechenwerk 3 zur Ermittlung eines Stellwertes für das Dämpfungsglied 1 aus dem digitalen Datenwort. Am Ausgang des Dämpfungsgliedes 1 liegt dann das geregelte HF-Pulssignal 10 an.

In einer vorteilhaften Ausführung der Schaltung ist ein Regeltaktgeber 12 vorhanden, welcher den von dem Rechenwerk 3 ermittelten Stellwert auf das Pulsdach desjenigen Pulses schaltet, für den die Regelabweichung ermittelt wurde.

Das Rechenwerk 3 umfasst zweckmäßig einen Speicher 13 zur Speicherung des an das Dämpfungsglied 1 zu übertragenden Stellwertes. Somit ist der Stellwert des vorherigen Regelvorgangs bekannt. Mittels des Stellwertspeichers 13 ist es möglich, basierend auf den jeweils aktuellen Einstellungen des digitalen Dämpfungsgliedes in einem neuen Regelvorgang eine weitere Korrektur vorzunehmen.
Angenommen das Dämpfungsglied ist mittels des Stellwertspeichers 13 auf den Wert 3 dB eingestellt bei dem die Amplitude des HF-Pulssignals 10 genau dem Sollwert entspricht. Wenn sich nun die Amplitude des ungeregelten HF-Pulssignals 9 um 1dB erhöht, kann die Dämpfung im Signalzug ebenfalls um 1dB erhöht werden, damit die Amplitude des HF-Pulssignals am Ausgang konstant bleibt. Mit anderen Worten, die Dämpfung kann am Dämpfungsglied um 1dB erhöht werden, um absolut einen Dämpfungswert von 4dB zu erhalten.

Das HF-Pulssignal ist nicht ständig vorhanden. Es wird z.B. nur für die Dauer von 30µs ausgesendet (d.h. die Pulsbreite beträgt 30µs) und ist dann z.B. für 1ms ausgeschaltet bevor es erneut ausgesendet wird. Anders ausgedrückt können wir sagen wir haben hier eine Pulsfolge mit einer Wiederholfrequenz von 1KHz bei 30µs Pulsbreite.

Der Regeltakt ist zweckmäßig mit dem Sendetakt des HF-Pulssignals synchronisiert. Somit ist gewährleistet, dass der Regeltakt zum richtigen Zeitpunkt (bei dem auch wirklich ein HF-Pulsdach vorhanden ist) den Stellwert der ermittelten Regelabweichung auf das Dämpfungsglied schaltet.

Diese erfindungsgemäße Art der Regelung unterscheidet sich von einer "kontinuierlichen" Regelung bei der das Ausgangssignal ständig vorhanden ist und somit auch ständig (eben kontinuierlich) nachgeregelt werden kann.

Das Dämpfungsglied 1 kann mit einem Startwertgeber 15 verbunden sein, welcher z.B. bei der Initialisierung der erfindungsgemäßen Schaltung einen Startwert in das Dämpfungsglied 1 schreibt, wobei der Startwert genau dem Stellwert entspricht, welcher das Dämpfungsglied 1 genau in die Mitte seines Stellbereichs stellt. Der Startwertgeber 15 kann den Startwert aber auch in den Speicher 13 zur Übertragung an das Dämpfungsglied 1 schreiben

Beispielhaft ist die erfindungsgemäße Schaltung derart ausgelegt, dass das Dämpfungsglied 1 mit einem 4-Bit breiten Datenwort angesteuert ist. Das Dämpfungsglied 1 kann somit auf 2⁴=16 Dämpfungswerte eingestellt werden. Um einen symmetrischen Regelbereich zu erhalten wird das Dämpfungsglied 1 bei Sollpegel (Regelabweichung = 0) z.B. mittels eines geeigneten Startwertes auf seinen mittleren Dämpfungswert eingestellt.

### Beispiel:

| Regelabweichung [dB] | Datenwort Bit | Absolute Dämpfungseinstellung [dB] |
|---|---|---|
| +3,5 | 0111 | 7,5dB |
| +3,0 | 0110 | 7,0dB |
| +0,5 | 0001 | 4,5dB |
| 0 | 0000 | 4,0dB *(Mittenstellung)* |
| -0,5 | 1111 | 3,5dB |
| -3,5 | 1001 | 0,5dB |
| -4,0 | 1000 | 0,0dB |

Das beispielhafte 4-Bit Dämpfungsglied kann ausgehend von der Mittenstellung seine Dämpfung um 3,5dB erhöhen und um 4dB verringern. Geht man jetzt von einer beispielhaften minimalen Dämpfungsänderung von 0,5dB aus, ergibt sich für den Fall n=4, mit n = Auflösung des A/D-Wandlers und des digitalen Dämpfungsgliedes in Bit, folgender Zusammenhang:

| | | |
|---|---|---|
| Stellbereich von -0,5 • [2⁴-2⁴⁻¹] dB | bis | +0,5 **•** [(2⁴-2⁴⁻¹)-1] dB |
| -4dB | | ... +3,5dB |

Allgemein können wir für den Stellbereich nun angeben:
- LSD • [2ⁿ-2ⁿ⁻¹] dB bis +LSD • [(2ⁿ-2ⁿ⁻¹)-1] dB, mit LSD = least significant Bit am digitalen Dämpfungsglied.

Der Ausgang des Dämpfungsgliedes 1 ist vorteilhaft mit einem Koppler 2 verbunden. Der Koppler 2 dient zum Auskoppeln von einem Teil der HF-Leistung des geregelten HF-Pulssignals 10 auf den Detektor 5. Die Auskopplung kann dabei, in Abhängigkeit von der Frequenz des HF-Pulssignals 10, wie folgt realisiert werden:
- durch einen Widerstandsteiler ( "6dB-Stern")
- durch zwei parallel verlaufende Leitungsstücke, die als geätzte Struktur auf der Leiterplatte realisiert werden (Leitungskoppler)
- durch ein diskretes Bauelement, ein sog. "Directional Coupler".

Zweckmäßig bleibt der Koppelfaktor, d.h. das Verhältnis von ausgekoppelter zu zugeführter Leistung über den relevanten Frequenzbereich des HF-Pulssignals konstant.

Der Detektor 5 wandelt die ausgekoppelte HF-Leistung in eine proportionale Gleichspannung um. Der Detektor 5 weist zweckmäßig einen linearen Zusammenhang zwischen der eingekoppelten HF-Leistung und der Ausgangsgleichspannung auf, wobei die so genannte Steilheit d.h. die Steigung der Detektorkennlinie (in dB/mV) über den relevanten Frequenzbereich konstant ist. Als Detektor können integrierte Bausteine verwendet werden.

Am Ausgang des Detektors 5 ist vorteilhaft ein Verstärker 6 angeschlossen. Dieser Verstärker 6 ist in einer besonderen Ausführungsform der Erfindung mit einem Eingang 7a eines Differenzverstärkers 7 verbunden. Der Ausgang 7c des Differenzverstärkers 7 ist vorteilhaft über einen Addierer 11 mit dem Eingang des Analog/Digital-Wandler 4 verbunden. Der andere Eingang 7b des Differenzverstärkers 7 sowie der Addierer 11 sind mit einer Stellspannungsversorgung 8 verbunden.

Die Stellspannung Uₛ der Spannungsversorgung 8 entspricht zweckmäßig genau der Spannung, die den A/D-Wandler 4 in die Mitte seines digitalen Aussteuerbereichs stellt.

Erfindungsgemäß erzeugt der A/D-Wandler 4 ein digitales Datenwort, welches in einem digitalen Rechenwerk 3 zu einem Stellwert weiterverarbeitet wird, welcher dem Dämpfungsglied 1 zugeführt wird. In einer vorteilhaften Ausführung der Erfindung entspricht die Bitbreite des digitalen Datenworts des A/D-Wandlers der Bitbreite des Dämpfungsgliedes 1.

Das Rechenwerk 3 kann einen Addierer 14 umfassen, welcher das von dem A/D-Wandler 4 erzeugte Datenwort vorzeichenrichtig mit dem Inhalt des Speichers 13 addiert. Der durch die Addition ermittelte Stellwert wird im Speicher 13 gespeichert und entsprechend des Regeltakts des Regeltaktgebers 12 auf das Dämpfungsglied 1 geschaltet. Dadurch wird gewährleistet, dass der Stellwert immer im richtigen Zeitpunkt, d.h. wenn das Pulsdach des HF-Pulssignals am digitalen Dämpfungsglied 1 anliegt, auf das Dämpfungsglied 1 und somit auf den HF-Puls gegeben wird.

Bei einem A/D-Wandler wird die minimale Auflösung üblicherweise als LSB (least significant Bit) angegeben. Ein beispielhafter 8-Bit Wandler kann seinen analogen Eingangsbereich in 2⁸ = 256 (0..255) diskrete Werte umsetzen. Die kleinste Wertänderung d.h. der Sprung zum nächsten diskreten digitalen Wert entspricht dabei dem LSB.
- Eingangsbereich: 5V
- Wandlerauflösung: 8 Bit
- LSB: 5V/ (256-1) = 19,6mV

D.h. der 8-Bit A/D-Wandier setzt seinen analogen Eingangsbereich in ein 8-Bit breites Datenwort um. Innerhalb des Datenworts werden das höchstwertige Bit mit MSB=most significant Bit und das niederwertigste Bit mit LSB=least signifcant Bit bezeichnet.
Gebräuchlich ist auch die einzelnen Bits innerhalb des Datenworts mit D7 (=MSB), D6, D5, D4, D3, D2, D1, D0 (=LSB) zu bezeichnen.

| Eingang A/D-Wandler Analoge Spannung | Ausgang A/D-Wandler Digitales Datenwort | |
|---|---|---|
| | D7 | D0 |
| 5,0000V | 11111111 | |
| 4,9804V | 11111110 | |
| 0,01960V | 00000001 | |
| 0,00000V | 00000000 | |

Werden am Ausgang des A/D-Wandlers z.B. nur 4-Bit (von insgesamt 8 möglichen) benötigt (Beispiel D5, D4, D3, D2) wird die höchstwertige Stelle (hier D5) mit MSD=most significant digit und die niederwertigste Stelle (hier D2) mit LSD=least significant digit bezeichnet.
In diesem Fall, mit den Datenbits D5..D2, muss sich die Eingangsspannung des A/D-Wandler um 5•LSB (=98,03mV) ändern, bevor eine Änderung am LSD D2 auftritt.

In einer vorteilhaften Ausführung der erfindungsgemäßen Schaltung ist die Verstärkung des Verstärkers 6 derart eingestellt, dass die Ausgangsspannung des Verstärkers 6 an dem Eingang 7a des Differenzverstärkers 7 genau der Stellspannung Uₛ am Eingang 7b des Differenzverstärkers 7 entspricht, wenn am Eingang des Verstärkers 6 ein HF-Pulssignal 10 mit Sollpegel anliegt, so dass die Ausgangsspannung des Differenzverstärkers 7 zu Null wird.

Die Verstärkung des Differenzverstärkers 7 ist vorteilhaft derart eingestellt, dass der Stellbereich von -LSD*[2ⁿ-2ⁿ⁻¹] dB bis +LSD*[(2ⁿ-2ⁿ⁻¹)-1] dB des Dämpfungsgliedes 1 genau auf den Aussteuerbereich des A/D-Wandlers 4 abgebildet ist.

Ändert sich der HF-Pegel des geregelten HF-Signals 10 bezüglich des ungeregelten HF-Signals 9 um z.B. +1,0dB, d.h. die Regelabweichung beträgt 1dB, so wird sich die Ausgangsspannung des Detektors 5 ebenfalls ändern.
Angenommen die Steilheit des Detektors beträgt 10mV/dB, so beträgt die Änderung am Detektorausgang +10mV. Wird diese Spannung mit Verstärker 6 und Differenzverstärker 7 nun mit dem Verstärkungsfaktor 9,803 verstärkt, so liegt am Eingang des A/D-Wandlers 4 genau der Spannungswert an, der das Datenwort DS...D2 am Ausgang des A/D-Wandlers 4 um den Wert 1 erhöht.

Ist in dem zugrunde liegenden Beispiel das digital einstellbare Dämpfungsglied 1 mit dem Datenwort D5...D2 angesteuert, so ändert das Dämpfungsglied 1 seine Dämpfungseinstellung bei Änderung des Datenworts entsprechend. Wenn das Dämpfungsglied 1 bei Änderung des Datenworts D5...D2 um den Wert 1 seine Dämpfung um genau 1dB erhöht, wird die auftretende Regelabweichung exakt ausgeglichen.

Die Verstärkung der Detektorspannung durch Verstärker 6 und Differenzverstärker 7 entspricht somit der Auflösung des von dem A/D-Wandler 4 erzeugten Datenworts. Ferner entspricht die Dämpfungsauflösung d.h. die minimale Dämpfungsvariation des einstellbaren Dämpfungsglieds genau dem LSD innerhalb des Datenworts, damit der Aussteuerungsbereich des Datenworts D5...D2 (das sind 16 Werte) genau den 16 möglichen Stellungen des digitalen Dämpfungsglieds 1 entspricht.

Mit anderen Worten, beim Auftreten einer Regelabweichung von ±x dB wird diese am Ausgang des Analog-Digitalwandlers 4 in die Form x = ± k * LSB umgesetzt. Zweckmäßig wird der Wert im digitalen Rechenwerk 3 vorzeichenrichtig zum aktuellen Stellwert addiert. Der daraus resultierende Stellwert wird an das digitale Dämpfungsglied 1 weitergegeben, das seine Dämpfung vorzeichenrichtig genau um x dB verstellt. Durch einen einmaligen Stellvorgang wird somit die Regelabweichung ausgeregelt und die Regelstrecke wieder auf ihre Sollwerte eingestellt. Im Gegensatz zu bekannten analogen Regelschaltungen wird der Sollwert nicht iterativ angenähert.

## Patentansprüche

1. Schaltung zur Amplitudenregelung von HF-Pulssignalen umfassend
ein digital einstellbares Dämpfungsglied (1) mit einem vorgebbaren Stellwertbereich zur Dämpfung eines am Eingang (1a) des Dämpfungsgliedes (1) zugeführten HF-Pulssignals (9),
einen A/D-Wandler (4) zur Umsetzung der Abweichung des Istpegels des am Ausgang (1b) des Dämpfungsgliedes (1) erzeugten Istsignals vom Sollpegel in ein digitales Datenwort,
ein digitales taktsynchrones Rechenwerk (3) zur Ermittlung eines Stellwertes für das Dämpfungsglied (1) aus dem digitalen Datenwort,
**dadurch gekennzeichnet, dass**
ein Regeltaktgeber (12) vorhanden ist zur zeitrichtigen Weitergabe des ermittelten Stellwertes auf das Pulsdach desjenigen Pulses für welchen die Regelabweichung ermittelt wurde.

2. Schaltung nach Anspruch 1, **dadurch gekennzeichnet, dass**
ein Stellwertgeber (15) vorhanden ist zur Zuführung eines Stellwerts an das digitale Dämpfungsglied (1), so dass das digitale Dämpfungsglied (1) auf seinen mittleren Dämpfungswert eingestellt ist.

3. Schaltung nach Anspruch 1 oder 2, **dadurch gekennzeichnet, dass**
die Bitbreite des digitalen Datenworts des A/D-Wandlers (4) der Bitbreite des Dämpfungsgliedes (1) entspricht.

4. Schaltung nach einem der vorangehenden Ansprüchen, **dadurch gekennzeichnet, dass**
am Ausgang (1b) des Dämpfungsgliedes (1) ein Koppler (2) vorhanden ist zur Auskopplung eines Teils der Leistung des HF-Signals auf einen Detektor (5) zur Erzeugung einer zur HF-Leistung proportionalen Gleichspannung.

5. Schaltung nach einem der vorangehenden Ansprüche, **dadurch gekennzeichnet, dass**
das digitale Rechenwerk (3) einen Speicher (13) umfasst zur Speicherung des an das Dämpfungsglied (1) zu übertragenden Stellwertes.

6. Schaltung nach einem der vorangehenden Ansprüche, **dadurch gekennzeichnet, dass**
ein Startwertgeber (15) vorhanden ist zur Zuführung eines Startwerts in das Dämpfungsglied (1), wobei der Startwert einem Stellwert entspricht, welcher das Dämpfungsglied (1) genau in die Mitte seines Stellbereichs stellt.

7. Schaltung nach Anspruch 5 oder 6, **dadurch gekennzeichnet, dass**
das digitale Rechenwerk (3) einen Addierer (14) umfasst zur vorzeichenrichtigen Addition des Inhalts des Speichers (13) mit dem vom A/D-Wandler (4) erzeugten Datenwort zur Ermittlung des Stellwerts für das Dämpfungsglied (1).

8. Schaltung nach Anspruch 4-7, **dadurch gekennzeichnet, dass**
ein Differenzverstärker (7) vorhanden ist, welcher an einem Eingang (7a) mit dem Ausgang des Detektors (5) verbunden ist.

9. Schaltung nach Anspruch 8, **dadurch gekennzeichnet, dass**
zwischen dem Eingang (7a) des Differenzverstärkers (7) und dem Ausgang des Detektors (5) ein Verstärker (6) geschaltet ist.

10. Schaltung nach Anspruch 8 oder 9, **dadurch gekennzeichnet, dass**
der Ausgang (7c) des Differenzverstärkers (7) mit dem Eingang des A/D-Wandlers (4) verbunden ist.

11. Schaltung nach Anspruch 9, **dadurch gekennzeichnet, dass**
eine Spannungsversorgung (8) vorhanden ist zur Zuführung einer vorgebbaren Stellspannung U_{S} an einen zwischen dem Ausgang (7c) des Differenzverstärkers (7) und dem Eingang des A/D-Wandlers (4) geschalteten Addierers (11) sowie an dem Eingang (7b) des Differenzverstärkers (7).

12. Schaltung nach Anspruch 11, **dadurch gekennzeichnet, dass**
die Stellspannung U_{S} der Eingangsspannung entspricht, die den A/D-Wandler (4) genau in die Mitte seines digitalen Aussteuerbereichs stellt.

13. Schaltung nach Anspruch 9-12, **dadurch gekennzeichnet, dass**
die Verstärkung des Verstärkers (6) derart eingestellt ist, dass die Ausgangsspannung des Verstärkers (6) an dem Eingang (7a) des Differenzverstärkers (7) genau der Stellspannung U_{S} am Eingang (7b) des Differenzverstärkers (7) entspricht, wenn am Eingang des Verstärkers (6) ein HF-Pulssignal mit Sollpegel anliegt, so dass die Ausgangsspannung des Differenzverstärkers (7) zu Null wird.

14. Schaltung nach Anspruch 8-12, **dadurch gekennzeichnet, dass**
die Verstärkung des Differenzverstärkers (7) derart eingestellt ist, dass der Stellbereich von -LSD*[2ⁿ-2ⁿ⁻¹] dB bis +LSD*[(2ⁿ-2ⁿ⁻¹)-1] dB des Dämpfungsgliedes (1) genau auf den Aussteuerbereich des A/D-Wandlers (4) abgebildet ist.
